Europäisches Patentamt

European Patent Office

Office européen des brevets

(19)

(11) EP 0 541 408 B1

# (12) FASCICULE DE BREVET EUROPEEN

(45) Date de publication et mention
de la délivrance du brevet:
**27.08.1997 Bulletin 1997/35**

(51) Int Cl.6: **H03L 7/199**, H03L 7/10,
H03L 7/18

(21) Numéro de dépôt: **92402653.7**

(22) Date de dépôt: **28.09.1992**

(54) **Procédé et dispositif de commande de mode de fonctionnement d'une boucle à verrouillage de phase numérique**

Verfahren und Einrichtung zum Steuern der Wirkungsweise eines digitalen Phasenregelkreises

Method and device for controlling the mode of functioning of a digital phase lock loop

(84) Etats contractants désignés:
**AT BE CH DE ES FR GB IT LI NL SE**

(30) Priorité: **04.10.1991 FR 9112265**

(43) Date de publication de la demande:
**12.05.1993 Bulletin 1993/19**

(73) Titulaire: **ALCATEL ALSTHOM COMPAGNIE GENERALE D'ELECTRICITE**
**75008 Paris (FR)**

(72) Inventeur: **Lafon, Jean-Luc**
**F-94170 Le Perreux sur Marne (FR)**

(74) Mandataire: **El Manouni, Josiane et al**
**ALCATEL ALSTHOM,**
**Département de Propriété Industrielle,**
**30, avenue Kléber**
**75116 Paris (FR)**

(56) Documents cités:
US-A- 3 989 931        US-A- 4 316 152
US-A- 4 587 496

• ELECTRONIC COMPONENTS AND APPLICATIONS vol. 9, no. 2, 31 Décembre 1989, EINDHOVEN,NL pages 66 - 89 W. ROSINK 'ALL-DIGITAL PHASE-LOCKED LOOPS USING THE 74HC/HCT297'

EP 0 541 408 B1

## Description

La présente invention est du domaine du traitement des signaux numériques. Elle concerne plus particulièrement les dispositifs appelés boucles à verrouillage de phase numériques.

De tels dispositifs sont bien connus, notamment par l'article : "All-digital phase-locked loops using the 74HC/HCT297" par Wim ROSINK dans ELECTRONIC COMPONENTS AND APPLICATIONS VOL 9 NO.2 pages 66 à 89 . On rappelle simplement qu'ils sont utilisés pour asservir la phase d'un signal numérique dit sortant, fourni par cette boucle, à celle d'un signal numérique dit entrant, reçu par cette boucle, et qu'ils procèdent essentiellement par incrémentation, ou décrémentation, de la fréquence d'un signal d'horloge fourni par un oscillateur interne à cette boucle en fonction de l'écart de phase existant entre lesdits signaux entrant et sortant.

Le signal de commande d'incrémentation ou de décrémentation de la fréquence du signal d'horloge fourni par ledit oscillateur est fourni par la sortie dite de débordement d'un compteur qui est déclenché par un signal représentatif dudit écart de phase, et qui compte au rythme d'un signal d'horloge également fourni par ledit oscillateur interne. L'asservissement de phase réalisé par une telle boucle s'accompagne donc d'un filtrage passebas, ou intégrateur, plus ou moins important suivant la plage de comptage de ce compteur, laquelle est en général réglable par action sur un, ou plusieurs, (suivant que ladite boucle est d'ordre égal à 1 ou supérieur à 1 ) coefficients de commande de ce compteur. La plage de comptage de ce compteur influence la durée nécessaire à l'accrochage de la boucle sur le signal d'entrée. Une faible plage entraîne une faible durée, alors qu'une large plage entraîne une longue durée.

Suivant l'application prévue pour une telle boucle, on peut, ou non, vouloir tirer parti d'un tel filtrage, sachant bien entendu que plus ce filtrage sera élevé, et plus le temps d'accrochage d'une telle boucle sera important. Le document mentionné ci-dessus décrit (page 85) une boucle à verrouillage de phase dans laquelle un microprocesseur diminue la plage de comptage du compteur lorsque ce microprocesseur reçoit un signal lui indiquant qu'il n'y a pas d'accrochage, et il augmente la plage de comptage lorsqu'il reçoit un signal indiquant qu'il y a accrochage, jusqu'à ce que l'erreur de phase soit minimale. Ce dispositif de détection d'accrochage n'est pas décrit. Ce document (Figure 24) indique seulement que cette détection est faite en fonction du signal d'entrée et du signal de sortie de la boucle.

Ce dispositif connu présente l'inconvénient de ne pas pouvoir être utilisé lorsque la fréquence est très élevée, 150 MHz par exemple, parce qu'un dispositif de commande par microprocesseur est alors beaucoup trop lent, et d'autre part parce que ce document ne décrit pas de dispositif de détection d'accrochage capable de travailler dans une boucle ayant un signal d'horloge dont la fréquence est très élevée. La présente invention vise plus particulièrement un type d'application où les deux objectifs de temps d'accrochage court et de filtrage important sont simultanément recherchés, et où la fréquence d'horloge est très élevée. L'invention s'applique particulièrement à la synchronisation d'un terminal de télécommunications raccordé à un réseau de télécommunication à transfert en mode asynchrone, par l'intermédiaire d'un dispositif dit adaptateur permettant de restituer vis-à-vis de ce terminal, une interface synchrone ; un tel dispositif adaptateur utilisant en effet une boucle à verrouillage de phase numérique pour générer un signal d'horloge dont la fréquence moyenne est égale à la fréquence de base de ladite interface synchrone, et dont la phase est asservie à celle d'un signal d'horloge entrant dont le rythme est égal au rythme des données reçues de ce réseau par ce dispositif adaptateur.

Une telle application requiert en effet simultanément, à

l'établissement d'une communication intéressant ce terminal, un temps d'accrochage relativement court de cette boucle et un filtrage relativement important afin de satisfaire aux conditions généralement sévères imposées par la norme régissant une telle interface, sur la gigue maximale admissible pour ledit signal d'horloge de fréquence moyenne égale à la fréquence de base de ladite interface synchrone.

La présente invention a pour objet un procédé de commande de mode de fonctionnement d'une boucle à verrouillage de phase numérique, ladite boucle comportant un compteur dit de commande d'incrémentation ou de décrémentation de la fréquence d'un signal d'horloge numérique interne à cette boucle, le signal d'entrée de ladite boucle étant présent par intermittence, avec un état de phase quelconque d'une présence à l'autre ; et ladite boucle à verrouillage de phase comportant un détecteur d'écart de phase entre ledit signal entrant et ledit signal sortant, et le signal de sortie de ce détecteur d'écart de phase présentant des transitions d'un premier type en coïncidence avec les transitions d'un type donné du signal sortant, et des transitions d'un second type en coïncidence avec les transitions d'un type donné du signal entrant ;

ce procédé de commande comportant, dans l'ordre, les étapes suivantes :

- détection d'un début de présence dudit signal d'entrée,
- sélection d'une plage de comptage dudit compteur ayant une valeur relativement faible en vue de permettre un accrochage relativement rapide de ladite boucle,
- détection d'accrochage de ladite boucle,
- sélection d'une plage de comptage dudit compteur ayant une valeur relativement forte, en vue de filtrer relativement fortement les éventuelles variations de phase dudit signal d'entrée se produisant au cours de ladite présence, ce dernier réglage étant conservé jusqu'à la prochaine détection d'un début de présence du signal d'entrée ;

**caractérisé** en ce que pour détecter l'accrochage, il consiste à :

- réaliser un échantillonnage du signal de sortie du détecteur de phase, par celles des transitions du signal sortant qui sont de type opposé audit type donné,
- mémoriser des groupes d'échantillons consécutifs, en nombre au moins égal à 3,
- et détecter l'instant où, pour la première fois, deux au moins desdits échantillons n'ont pas le même niveau logique.

L'invention a aussi pour objet un dispositif de commandé de mode de fonctionnement d'une boucle à verrouillage de phase numérique, le signal d'entrée de ladite boucle étant présent par intermittence, avec un état de phase quelconque d'une présence à l'autre ; ladite boucle comportant :

- un compteur dit de commande d'incrémentation ou de décrémentation de la fréquence d'un signal d'horloge numérique interne à cette boucle,
- un détecteur d'écart de phase entre ledit signal entrant et ledit signal sortant, et le signal de sortie de ce détecteur d'écart de phase présentant des transitions d'un premier type en coïncidence avec les transitions d'un type donné du signal sortant, et des transitions d'un second type en coïncidence avec les transitions d'un type donné du signal entrant ;
- des moyens de détection d'un début de présence dudit signal d'entrée,
- des moyens de détection d'accrochage de ladite boucle,
- des moyens de sélection d'une plage de comptage dudit compteur, pour sélectionner, lors de la détection d'un début de présence dudit signal d'entrée, une plage ayant une valeur relativement faible en vue de permettre un accrochage relativement rapide de ladite boucle, puis sélectionner une plage ayant une valeur relativement forte, lors de la détection

  d'accrochage de ladite boucle, en vue de filtrer relativement fortement les éventuelles variations de phase dudit signal d'entrée se produisant au cours de ladite présence, ce dernier réglage étant conservé jusqu'à la prochaine détection d'un début de présence du signal d'entrée ;

**caractérisé** en ce que les moyens de détection d'accrochage comportant :

- des moyens pour réaliser un échantillonnage du signal de sortie du détecteur de phase, par celles des transitions du signal sortant qui sont de type opposé audit type donné, et pour mémoriser des groupes d'échantillons consécutifs, en nombre au moins égal à 3,
- et des moyens de détection de l'instant où, pour la première fois, deux au moins desdits échantillons n'ont pas le même niveau logique.

D'autres objets et caractéristiques de la présente invention apparaîtront à la lecture de la description suivante d'un exemple de réalisation, faite en relation avec les dessins ci-annexés dans lesquels :

- la figure 1 est un schéma synoptique d'un dispositif de commande suivant l'invention, représenté avec la boucle à verrouillage de phase numérique à laquelle il s'applique,
- la figure 2 est un schéma de réalisation possible des moyens de détection d'accrochage de la boucle à verrouillage de phase et de commande de sélection de plage de comptage, intervenant dans ce dispositif de commande,
- la figure 3 est un schéma de réalisation possible des moyens de détection d'un début de présence de signal entrant, intervenant dans ce dispositif de commande,
- la figure 4 est un chronogramme destiné à illustrer ladite commande de sélection de plage de comptage.

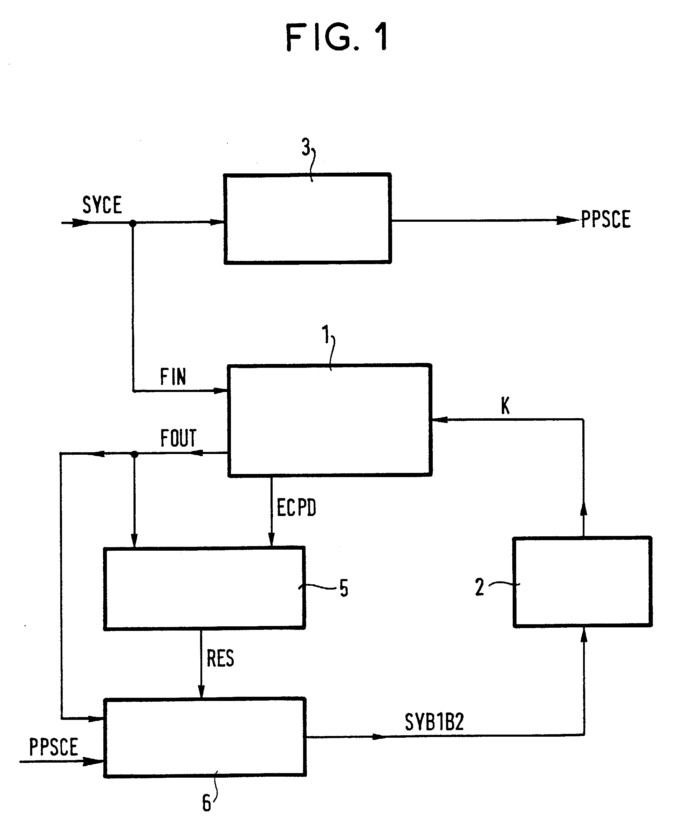

Sur la figure 1 est référencée 1 une boucle à verrouillage de phase numérique qui est par exemple d'ordre égal à 1. Cette boucle à verrouillage de phase, dont la constitution interne n'est pas rappelée sur cette figure, reçoit un signal dit entrant, noté FIN, et fournit un signal dit sortant, noté FOUT. Cette boucle reçoit en outre, via un moyen 2 de sélection de coefficient, un coefficient K de commande de la plage de comptage de son compteur de commande d'incrémentation ou de décrémentation, et fournit en outre un signal, noté ECPD, de sortie de son détecteur de phase.

Ce détecteur de phase est en l'occurrence un détecteur dit à commande par les transitions des signaux qui lui sont appliqués, et on considérera, par exemple, dans ce qui suit, qu'une transition descendante du signal FOUT provoque un passage à un niveau haut de ce signal ECPD, et qu'une transition descendante consécutive du signal FIN provoque un passage à un niveau bas de ce signal ECPD.

Sur la figure 1 est en outre référencé 3 un moyen de détection d'un début de présence de signal entrant. Dans le cas de l'exemple d'application rappelé plus haut, à la synchronisation d'un terminal de télécommunications raccordé à un réseau de télécommunications à transfert en mode asynchrone, le signal entrant, lorsqu'il est présent, est formé d'une suite de cellules, ou paquets de longueur fixe, les cellules d'une même suite étant relatives à une même communication établie via un tel réseau. Les suites de cellules ainsi obtenues sont alors présentes de façon intermittente, au gré des apparitions et des disparitions de communications intéressant le terminal considéré.

Le moyen de détection 3 reçoit un signal numérique noté SYCE dont le rythme est constitué par le rythme d'arrivée de ces cellules, ce signal constituant, pour la boucle à verrouillage de phase, le signal d'entrée FIN de cette boucle.

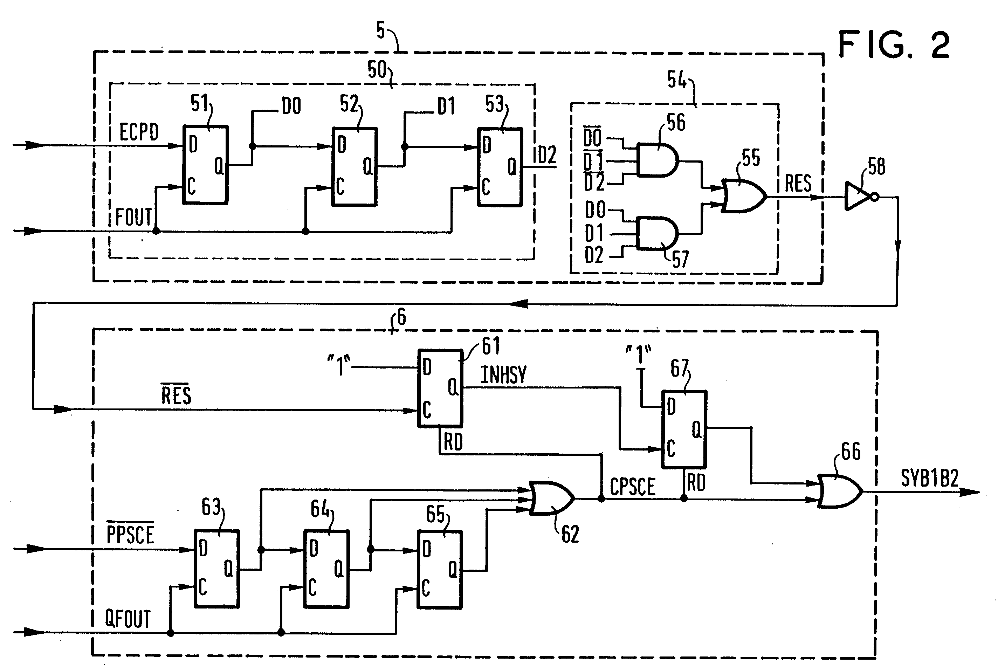

Sur la figure 1 est en outre référencé 5 un moyen de détection d'accrochage de la boucle à verrouillage de phase 1, qui opère à partir des signaux ECPD et FOUT d'une façon qui sera décrite ultérieurement en relation avec la figure 2, et 6 un moyen de commande du moyen 2 de sélection de coefficient, qui opère à partir du signal RES fourni par le moyen 5 et à partir des signaux PPSCE et FOUT, d'une façon qui sera décrite ultérieurement en relation avec la figure 2, pour fournir un signal, noté SYB1B2, de commande de ce moyen 2 de sélection de coefficient.

Le moyen 5 de détection d'accrochage comporte, selon cette figure 2, des moyens 50 d'échantillonnage du signal ECPD par le signal FOUT et de mémorisation d'un certain nombre, égal ici à trois mais qui pourrait être supérieur à cette valeur, d'échantillons consécutifs ainsi obtenus.

Ces moyens 50 comportent en l'occurrence trois bascules du type D, 51, 52, 53 dont l'entrée d'horloge, référencée C, reçoit le signal FOUT, l'entrée "D" de la bascule 51 recevant le signal ECPD, l'entrée "D" de la bascule 52 le signal D0 fourni par la sortie "Q" de la bascule 51, et l'entrée D de la bascule 53 le signal D1 fourni par la sortie Q de la bascule 52, le signal fourni par la sortie Q de la bascule 53 étant en outre référencé D2.

Le moyen 5 de détection d'accrochage comporte également un circuit 54 de détection de valeurs non identiques de deux des échantillons mémorisés dans les moyens 50.

Ce circuit 54 comporte en l'occurrence une porte "OU" 55 dont une première entrée reçoit le signal de sortie d'une porte ET 56 recevant les signaux D0, D1 et D2 inversés, notés $\overline{D0}$, $\overline{D1}$, $\overline{D2}$, et dont une deuxième entrée reçoit le signal de sortie d'une porte ET 57 recevant les signaux D0, D1 et D2.

Le signal de sortie de la porte OU 55 constitue le signal RES de sortie des moyens de détection d'accrochage.

L'invention utilise en effet la propriété qu'a le signal ECPD de sortie d'un détecteur de phase dit à commande par les transitions des signaux qui lui sont appliqués de conduire à l'obtention de deux tels échantillons de niveaux opposés, entourant un instant d'accrochage dit idéal, non accessible en pratique du fait que la boucle procède par incréments ou décréments de fréquence, c'est-à-dire par variation, de façon discontinue, et non de façon continue, de cette fréquence.

L'instant d'accrochage ainsi détecté par les moyens 5 est alors obtenu lorsque, parmi les trois échantillons ainsi mémorisés, deux d'entre eux ont pour la première fois, des niveaux opposés.

En pratique, le signal ECPD vérifiant une telle propriété relativement fréquemment une fois l'accrochage réalisé, et relativement peu fréquemment avant que cet accrochage ne soit réalisé, le signal RES n'est pas exploité tel quel par les moyens 2 de sélection de coefficient de la figure 1, mais après traitement, dans un circuit 6, de la façon maintenant décrite.

Un signal, référencé INHSY, est tout d'abord fabriqué au moyen d'une bascule "D" 61 qui reçoit sur son entrée D un niveau logique "1" et sur son entrée d'horloge un signal, noté $\overline{RES}$, obtenu par inversion du signal RES au moyen d'un inverseur 58.

La bascule 61 reçoit en outre sur son entrée de remise à zéro, notée RD, un signal, noté CPSCE, élaboré de la façon suivante.

Ce signal CPSCE est obtenu en sortie d'une porte OU 62 munie de trois entrées connectées respectivement à la sortie Q de trois bascules 63, 64, 65 connectées en cascade, c'est-à-dire avec la sortie Q de la première d'entre elles, 63, connectée à l'entrée D de la deuxième d'entre elles, 64, et la sortie Q de cette deuxième bascule connectée à l'entrée D de la troisième bascule, 65.

L'entrée D de la première bascule 63 reçoit en outre le signal PPSCE inversé, noté $\overline{PPSCE}$, et l'entrée d'horloge de ces trois bascules reçoit un signal QFOUT de fréquence égale au quart de la fréquence du signal FOUT.

Le signal INHSY permet ainsi de ne prendre en compte, à titre de premier basculement du signal RES, correspondant à l'accrochage, que celui des basculements de ce signal qui intervient pour la première fois au bout d'une certaine durée après une détection de début de présence de signal d'entrée, cette durée correspondant en l'occurrence à quatre périodes du signal FOUT.

Le signal SYB1B2 de commande de sélection de coefficient est obtenu en sortie d'une porte OU 66 munie de deux entrées qui reçoivent respectivement le signal CPSCE, et le signal fourni par la sortie Q d'une bascule "D" 67 dont l'entrée "D" reçoit un niveau logique "1", dont l'entrée d'horloge reçoit le signal INHSY, et dont l'entrée de remise à zéro reçoit le signal CPSCE.

Ainsi lorsque l'on se situe entre une détection de début de présence de signal d'entrée et une détection d'accrochage, le signal SYB1B2 a un premier niveau logique conduisant à la sélection d'une première valeur de coefficient, correspondant à une plage de comptage relativement faible afin de réduire la durée d'accrochage, et lorsque l'on se situe après une détection d'accrochage, ou en l'absence de signal d'entrée FIN, le signal SYB1B2 a un second niveau logique conduisant à la sélection d'une deuxième valeur de coefficient, correspondant à une plage de comptage relativement forte afin de filtrer efficacement les variations de phase du signal d'entrée FIN.

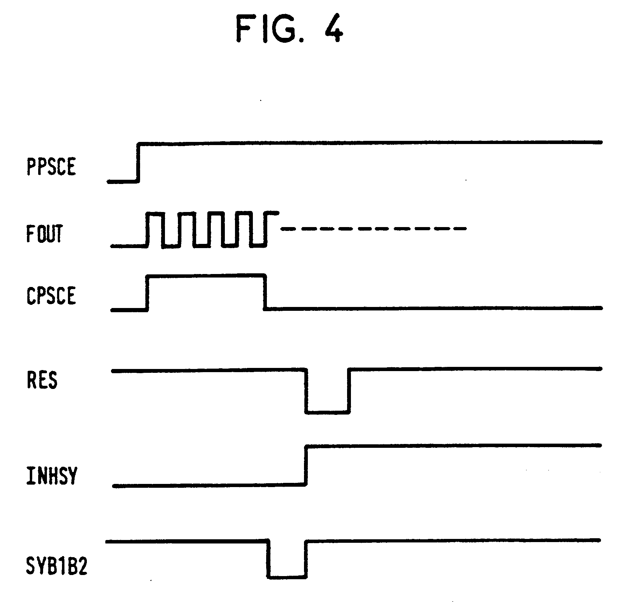

La figure 4 représente un chronogramme destiné à illustrer ce mode de sélection de plage de comptage. Sur la première ligne de ce chronogramme on a représenté le signal PPSCE dont le passage du niveau logique O au niveau logique 1 indique une détection de début de présence de signal d'entrée.

A la deuxième ligne de ce chronogramme est représenté le signal FOUT.

A la troisième ligne de ce chronogramme est représenté le signal CPSCE qui prend un niveau logique "1" à la première transition du signal FOUT intervenant après la transition du signal PPSCE, et qui conserve dans cet exemple ce niveau logique "1" pendant quatre périodes consécutives du signal FOUT.

A la quatrième ligne de ce chronogramme est représenté le signal RES qui présente une transition descendante correspondant à un accrochage de la boucle à verrouillage de phase. Cette transition descendante est en pratique suivie d'une transition montante, comme illustré sur ce chronogramme.

A la cinquième ligne de ce chronogramme est illustré le signal INHSY qui passe du niveau logique "O" au niveau logique "1" à cette transition descendante du signal RES et qui conserve ensuite ce niveau logique "1" tant que le signal CPSCE conserve le niveau logique "O".

A la dernière ligne de ce chronogramme est représenté le signal SYB1B2 de commande de sélection de coefficients. Quand le signal CPSCE passe au niveau logique 1 il remet au niveau logique 0 les sorties Q des bascules 61 et 67. Le signal SYB1B2 passe au niveau logique 0 lorsque le signal CPSCE repasse au niveau logique 0. Puis lé signal SYB1B2 passe au niveau logique 1, le signal CPSCE étant au niveau logique 0.

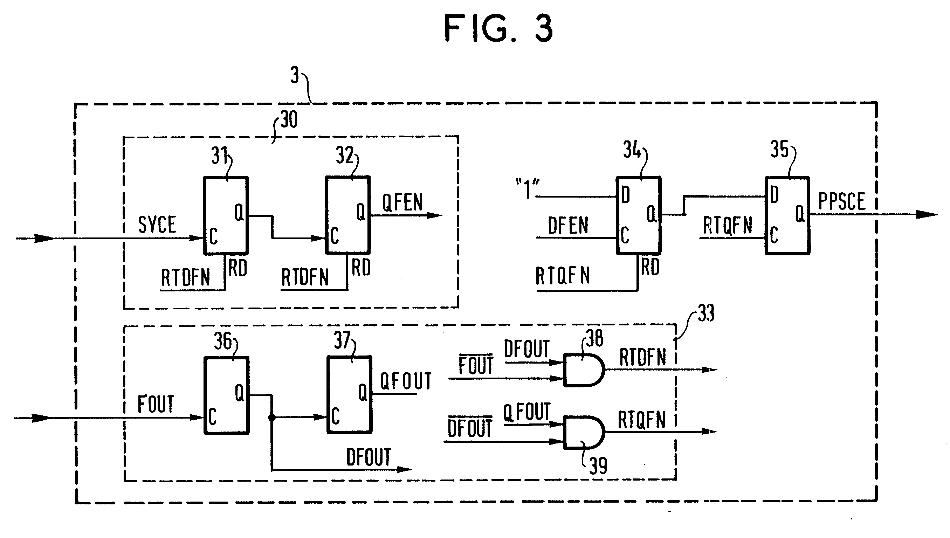

Les moyens 3 de détection de début de présence de signal d'entrée, représentés figure 3 procédent essentiellement par division par "n" du rythme du signal incident SYCE, de façon à compter "n" cellules incidentes successives, et par prise en compte du résultat de ce comptage à un rythme dérivé en l'occurrence du signal sortant FOUT, et obtenu par division par la même valeur "n" du rythme de ce signal FOUT.

Dans l'exemple illustré sur la figure 3, le nombre "n" a été choisi égal à 4. Ces moyens de détection comportent ainsi un compteur par "n", 30, formé de deux bascules 31 et 32 mises en cascade, c'est-à-dire avec la sortie Q de la première bascule 31 reliée à l'entrée d'horloge de la deuxième bascule 32. L'entrée d'horloge de la bascule 31 reçoit en outre le signal de rythme incident SYCE et le signal de sortie de la bascule 32 est noté QFEN. Ces deux bascules 31 et 32 sont remises à zéro respectivement par un signal RTDFN et par un signal RTQFN élaborés par un générateur 33 de signaux d'horloge dérivés du signal FOUT.

Le signal QFEN issu du compteur 30 est appliqué à l'entrée d'horloge d'une bascule du type "D" 34 dont l'entrée D est mise au niveau logique "1".

La sortie Q de la bascule 34 est reliée à l'entrée D d'une bascule 35 dont l'entrée d'horloge reçoit un signal RTQFN délivré par le générateur 33. La sortie Q de la bascule 35 fournit le signal PPSCE d'indication d'un début de présence du signal d'entrée.

La bascule 34 reçoit également sur son entrée de remise à zéro le signal RTQFN fourni par le générateur 33.

Le générateur 33 comporte dans cet exemple un diviseur de fréquence par quatre, comportant deux bascules 36 et 37 montées en cascade de façon analogue aux bascules 31 et 32. La bascule 36 reçoit en outre sur son entrée d'horloge le signal FOUT et fournit sur sa sortie Q un signal noté DFOUT, et la bascule 37 fournit sur sa sortie Q un signal noté QFOUT.

Le générateur 33 comporte en outre une porte ET 38 qui reçoit le signal DFOUT et le signal FOUT inversé, noté $\overline{FOUT}$, et qui fournit le signal RTDFN.

Le générateur 33 comporte également une porte ET 39 qui reçoit le signal QFOUT et le signal DFOUT inversé, noté $\overline{DFOUT}$, et qui fournit le signal RTQFN.

## Revendications

1. Procédé de commande de mode de fonctionnement d'une boucle (1) à verrouillage de phase numérique, ladite boucle comportant un compteur dit de commande d'incrémentation ou de décrémentation de la fréquence d'un signal d'horloge numérique interne à cette boucle, le signal d'entrée (FIN) de ladite boucle étant présent par intermittence, avec un état de phase quelconque d'une présence à l'autre ; et ladite boucle à verrouillage de phase (1) comportant un détecteur d'écart de phase entre ledit signal entrant et ledit signal sortant, et le signal de sortie de ce détecteur d'écart de phase présentant des transitions d'un premier type en coïncidence avec les transitions d'un type donné du signal sortant, et des transitions d'un second type en coïncidence avec les transitions d'un type donné du signal entrant ;

ce procédé de commande comportant, dans l'ordre, les étapes suivantes :

- détection d'un début de présence dudit signal d'entrée,
- sélection d'une plage de comptage dudit compteur ayant une valeur relativement faible en vue de permettre un accrochage relativement rapide de ladite boucle,
- détection d'accrochage de ladite boucle,
- sélection d'une plage de comptage dudit compteur ayant une valeur relativement forte, en vue de filtrer relativement fortement les éventuelles variations de phase dudit signal d'entrée se produisant au cours de ladite présence, ce dernier réglage étant conservé jusqu'à la prochaine détection d'un début de présence du signal d'entrée ;

**caractérisé** en ce que pour détecter l'accrochage, il consiste à :

- réaliser un échantillonnage du signal (ECPD) de sortie du détecteur de phase, par celles des transitions du signal sortant (FOUT) qui sont de type opposé audit type donné,
- mémoriser des groupes d'échantillons consécutifs, en nombre au moins égal à 3,
- et détecter l'instant où, pour la première fois, deux au moins desdits échantillons n'ont pas le même niveau logique.

2. Dispositif de commande de mode de fonctionnement d'une boucle (1) à verrouillage de phase numérique, le signal d'entrée (FIN) de ladite boucle étant présent par intermittence, avec un état de phase quelconque d'une présence à l'autre ; ladite boucle (1) comportant :

- un compteur dit de commande d'incrémentation ou de décrémentation de la fréquence d'un signal d'horloge numérique interne à cette boucle,
- un détecteur d'écart de phase entre ledit signal entrant et ledit signal sortant, et le signal de sortie de ce détecteur d'écart de phase présentant des transitions d'un premier type en coïncidence avec les transitions d'un type donné du signal sortant, et des transitions d'un second type en coïncidence avec les transitions d'un type donné du signal entrant ;
- des moyens (3) de détection d'un début de présence dudit signal d'entrée,
- des moyens (5) de détection d'accrochage de ladite boucle,
- des moyens (2) de sélection d'une plage de comptage dudit compteur, pour sélectionner, lors de la détection d'un début de présence dudit signal d'entrée, une plage ayant une valeur relativement faible en vue de permettre un accrochage relativement rapide de ladite boucle, puis sélectionner une plage ayant une valeur relativement forte, lors de la détection d'accrochage de ladite boucle, en vue de filtrer relativement fortement les éventuelles variations de phase dudit signal d'entrée se produisant au cours de ladite présence, ce dernier réglage étant conservé jusqu'à la prochaine détection d'un début de présence du signal d'entrée ;

      **caractérisé** en ce que les moyens (5) de détection d'accrochage comportent :

- des moyens (51, 52, 53) pour réaliser un échantillonnage du signal de sortie du détecteur de phase, par celles des transitions du signal sortant qui sont de type opposé audit type donné, et pour mémoriser des groupes d'échantillons consécutifs, en nombre au moins égal à 3,

- et des moyens (54) de détection de l'instant où, pour la première fois, deux au moins desdits échantillons n'ont pas le même niveau logique.

3. Dispositif pour la mise en oeuvre du procédé suivant la revendication 1, **caractérisé** en ce qu'il comporte, pour réaliser ladite sélection de plage de comptage, un générateur de signal binaire (SYB1B2) comportant :

- une bascule (67) du type "D" dont l'entrée D est mise au niveau logique "1", dont l'entrée d'horloge reçoit un signal issu de moyens de détection d'accrochage (5), et dont l'entrée de remise à zéro reçoit un signal issu, à travers des moyens de temporisation (61 à 65), de moyens (3) de détection de début de présence du signal entrant,
- une porte logique (66) du type "OU" qui reçoit d'une part le signal fourni par la sortie Q de ladite bascule, d'autre part le signal appliqué à l'entrée de remise à zéro de ladite bascule, et qui fournit ledit signal binaire (SYB1B2).

**Patentansprüche**

1. Verfahren zur Steuerung des Betriebs einer digitalen Phasenverriegelungsschleife (1), die einen Zähler zur Steuerung der Frequenz eines internen digitalen Taktsignals dieser Schleife durch Inkrementierung oder Dekrementierung enthält, wobei das Eingangssignal (FIN) der Schleife intermittierend mit einer beliebigen Phasenlage zwischen einem und dem nächsten Auftreten vorliegt und wobei die Phasenverriegelungsschleife (1) einen Detektor für den Phasenabstand zwischen dem ankommenden und dem ausgehenden Signal besitzt, dessen Ausgangssignal Übergänge eines ersten Typs in Koinzidenz mit den Übergängen eines bestimmten Typs des Ausgangssignals und Übergänge eines zweiten Typs in Koinzidenz mit den Übergängen eines gegebenen Typs des Eingangssignals aufweist,

      wobei das Steuerverfahren in dieser Reihenfolge folgende Verfahrensschritte aufweist:

- Erfassung eines Beginns des Vorliegens des Eingangssignals,
- Auswahl eines Zählbereichs des Zählers mit relativ kleinem Wert, um ein relativ schnelles Einrasten der Schleife zu erlauben,
- Erfassung des Einrastens der Schleife,
- Auswahl eines Zählbereichs des Zählers mit einem relativ großen Wert, um relativ stark die möglichen Veränderungen der Phase des Eingangssignals zu filtern, die während des Vorliegens dieses Signals auftreten, wobei diese letztgenannte Einstellung bis zur nächsten Erfassung des Beginns des Vorliegens des Eingangssignals beibehalten bleibt,

dadurch gekennzeichnet, daß zur Erfassung des Einrastens das Verfahren darin besteht:

- das Signal (ECPD) am Ausgang des Phasendetektors durch diejenigen Übergänge des Ausgangssignals (FOUT) zu tasten, die entgegengesetzt zu dem gegebenen Typ sind,
- Gruppen von mindestens drei aufeinanderfolgenden Tastproben zu speichern,
- und den Zeitpunkt zu erfassen, an dem zum ersten Mal mindestens zwei Tastproben den gleichen logischen Wert haben.

2. Vorrichtung zur Steuerung des Betriebs einer digitalen Phasenverriegelungsschleife (1), deren Eingangssignal (FIN) intermittierend mit beliebiger Phasenlage zwischen einem und dem nächsten Auftreten vorliegt, wobei die Schleife (1) enthält:

- einen Zähler zur Steuerung der Frequenz eines internen Taktsignals dieser Schleife durch Inkrementierung oder Dekrementierung,
- einen Detektor für den Phasenabstand zwischen dem Eingangs- und Ausgangssignal, dessen Ausgangssignal Übergänge eines ersten Typs in Koinzidenz mit den Übergängen eines gegebenen Typs des Ausgangssignals und Übergänge eines zweiten Typs in Koinzidenz mit den Übergängen eines gegebenen Typs des Eingangssignals aufweist,
- Mittel (3) zur Erfassung eines Beginns des Vorliegens des Eingangssignals,
- Mittel (5) zur Erfassung des Einrastens der Schleife,
- Mittel (2) zur Auswahl eines Zählbereichs des Zählers, um bei der Erfassung eines Beginns des Vorliegens des Eingangssignals einen Zählbereich mit relativ kleinem Wert auszuwählen, der ein relativ rasches Einrasten der Schleife erlaubt, und dann einen Zählbereich mit relativ großem Wert auszuwählen, wenn das Einrasten der Schleife erfaßt wurde, um die eventuellen Veränderungen der Phase des Eingangssignals, die sich während des Vorliegens dieses Signals zeigen, relativ stark zu filtern, wobei diese Einstellung bis zur nächsten Erfassung eines Beginns des Vorliegens des Eingangssignals beibehalten bleibt,

dadurch gekennzeichnet, daß die Mittel (5) zur Erfassung des Einrastens aufweisen:

- Mittel (51, 52, 53), um das Ausgangssignal des Phasendetektors mit denjenigen Übergängen des Ausgangssignals zu tasten, die dem gegebenen Typ entgegengesetzt sind, und um Gruppen von mindestens drei aufeinanderfolgenden Tastproben zu speichern,
- und Mittel (54) zur Erfassung des Zeitpunkts, an dem zum ersten Mal mindestens zwei der Tastproben nicht den gleichen logischen Wert haben.

3. Vorrichtung zur Durchführung des Verfahrens nach Anspruch 1, dadurch gekennzeichnet, daß es für die Auswahl des Zählbereichs einen Binärsignalgenerator (SYB1B2) enthält, der aufweist:

- eine D-Kippstufe (67), deren Eingang D den logischen Pegel 1 empfängt, deren Takteingang ein Signal von Mitteln (5) zur Erfassung des Einrastens empfängt und deren Nullsetzungseingang ein Signal empfängt, das über Zeitverzögerungsmittel (61 bis 65) von Mitteln (3) zur Erfassung des Beginns des Vorliegens des Eingangssignals geliefert wird,
- ein logisches ODER-Tor (66), das einerseits das vom Ausgang Q der Kippstufe gelieferte Signal und andererseits das Signal empfängt, das auch an den Nullsetzungseingang der Kippstufe angelegt wird, wobei der Ausgang des ODER-Tors das Binärsignal (SYB1B2) liefert.

**Claims**

1. Method for controlling the operating mode of a digital phase-locked loop (1), said loop comprising a counter controlling incrementing or decrementing of the frequency of a digital clock signal internal to said loop, the input signal (FIN) of said loop being present intermittently, with random phase from one appearance to the next, and said phase-locked loop (1) including a detector of the phase difference between said input signal and said output signal, and the output signal of said phase difference detector having transitions of a first type coinciding with transitions of a given type in the output signal and transitions of a second type coinciding with transitions of a given type in the input signal;

the control method comprising, in this order, the following steps:

- detecting the appearance of said input signal,
- selecting a relatively low capacity of said counter to enable relatively fast synchronisation of said loop,
- detecting synchronisation of said loop,
- selecting a relatively high capacity of said counter to filter relatively strongly any phase variations of said input signal occurring while it is present, this latter adjustment being retained until the next detection of the appearance of the input signal;

characterised in that, to detect synchronisation, it consists in:

- sampling the phase detector output signal (ECPD) using the transitions of the output signal (FOUT) which are of the type opposite to said given type,
- holding groups of at least three consecutive samples, and
- detecting the time at which at least two of the samples have different logical values for the first time.

2. Device for controlling the operating mode of a digital phase-locked loop (1), the input signal (FIN) of said loop being present intermittently, with random phase from one appearance to the next, said loop (1) including:

- a counter controlling incrementing or decrementing of the frequency of a digital clock signal internal to said loop,
- a detector of the phase difference between said input signal and said output signal, the output signal of said phase difference detector having transitions of a first type coinciding with transitions of a given type in the output signal and transitions of a second type coinciding with transitions of a given type in the input signal,
- means (3) for detecting the appearance of said input signal,
- means (5) for detecting synchronisation of said loop,
- means (2) for selecting a relatively low capacity of said counter upon detecting the appearance of said input signal to enable relatively rapid synchronisation of said loop, followed by selecting a relatively high capacity of said counter upon detecting synchronisation of said loop to filter relatively strongly any phase variations of said input signal occurring while it is present, this latter adjustment being retained until the next detection of the appearance of the input signal,

characterised in that the synchronisation detection means (5) include:

- means (51, 52, 53) for sampling the output signal of the phase detector on transitions of the output signal which are of the type opposite to said given type, and for holding groups of at least three consecutive samples, and
- means (54) for detecting the moment at which at least two of said samples have different logical values for the first time.

3. Device for implementing the method according to claim 1 characterised in that it comprises, for selecting said counter capacity, a binary signal (SYB1B2) generator comprising:

- a D type flip-flop (67) whose D input has the logical value 1, whose clock input receives a signal from synchronisation detector means (5) and whose reset input receives via time-delay means (61-65) a signal from means (3) for detecting the appearance of the input signal,
- an OR logic gate (66) which receives the signal supplied by the Q output of said flip-flop and the signal applied to the reset input of said flip-flop and which supplies said binary signal (SYB1B2).

# FIG. 1

# FIG. 2

# FIG. 3

EP 0 541 408 B1

# FIG. 4